(19) Europäisches Patentamt
European Patent Office
Office européen des brevets

(11) **EP 4 495 286 A1**

(12) # EUROPEAN PATENT APPLICATION
published in accordance with Art. 153(4) EPC

(43) Date of publication:
**22.01.2025 Bulletin 2025/04**

(21) Application number: **23780877.9**

(22) Date of filing: **30.03.2023**

(51) International Patent Classification (IPC):
**C23C 14/06** (2006.01)    **H01L 21/318** (2006.01)
**H10B 53/30** (2023.01)    **H10N 30/076** (2023.01)
**H10N 30/853** (2023.01)

(52) Cooperative Patent Classification (CPC):
**C23C 14/06; H01L 21/31; H10B 53/30;
H10N 30/076; H10N 30/853**

(86) International application number:
**PCT/JP2023/013181**

(87) International publication number:
**WO 2023/190869 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.03.2022 JP 2022060739
25.08.2022 JP 2022134199**

(71) Applicants:
• **Tosoh Corporation
Yamaguchi 746-8501 (JP)**
• **Tokyo Institute of Technology
Tokyo 152-8550 (JP)**

(72) Inventors:
• **MESUDA, Masami
Ayase-shi, Kanagawa 252-1123 (JP)**
• **KUSUSE, Yoshiro
Ayase-shi, Kanagawa 252-1123 (JP)**

• **IIHAMA, Junya
Ayase-shi, Kanagawa 252-1123 (JP)**
• **SUEMOTO, Yuya
Ayase-shi, Kanagawa 252-1123 (JP)**
• **UEOKA, Yoshihiro
Ayase-shi, Kanagawa 252-1123 (JP)**
• **FUNAKUBO, Hiroshi
Tokyo 152-8550 (JP)**
• **SHIRAISHI, Takahisa
Tokyo 152-8550 (JP)**
• **YASUOKA, Shinnosuke
Tokyo 152-8550 (JP)**
• **MIZUTANI, Ryoichi
Tokyo 152-8550 (JP)**
• **OTA, Reika
Tokyo 152-8550 (JP)**

(74) Representative: **Novagraaf International SA
Chemin de l'Echo 3
1213 Onex, Geneva (CH)**

(54) **ALUMINUM SCANDIUM NITRIDE FILM AND FERROELECTRIC ELEMENT**

(57) An aluminum scandium nitride film contains aluminum, scandium, and nitrogen and further contains gallium. A crystal phase of the aluminum scandium nitride film may include a hexagonal crystal. The crystal phase of the aluminum scandium nitride film may have a wurtzite structure.

**Fig.1**

## Description

## Technical Field

The present disclosure relates to an aluminum scandium nitride film and a ferroelectric element.

## Background Art

Aluminum scandium nitride films are known to exhibit the highest ferroelectricity among ferroelectrics, and expected to be applied to storage elements such as ferroelectric memories, piezoelectric elements such as pressure sensors and vibration sensors, and the like.

A known example of such an aluminum scandium nitride film is described in Patent literature 1 below. Patent Literature 1 below proposes that the ferroelectricity of aluminum scandium nitride films is improved by decreasing the concentration of scandium.

## Citation List

## Non Patent Literature

Non Patent Literature 1: Yasuoka et al., "Effects of deposition conditions on the ferroelectric properties of (Al1-xScx)N thin films", J. Appl. Phys., 128, 114103, 2020

## Summary of Invention

## Technical Problem

However, the aluminum scandium nitride films described in NPL 1 still have room for improvement in a decrease in the coercive electric field and an increase in the remanent polarization.

An object of the present disclosure is to provide at least one of an aluminum scandium nitride film capable of increasing the remanent polarization while decreasing the coercive electric field and a ferroelectric element including the aluminum scandium nitride film.

## Solution to Problem

The inventors of the present disclosure have focused on the replacement of some aluminum with gallium, which is a homologous element of aluminum, in an aluminum scandium nitride film. It has been found that, however, gallium scandium nitride films in which all of aluminum is replaced with gallium have lower remanent polarization than aluminum scandium nitride films. In contrast, surprisingly, it has been found that replacing some, but not all, of aluminum in an aluminum scandium nitride film with gallium increases the remanent polarization and decreases the coercive electric field.

The present disclosure has been made based on this finding. The content of the present invention is described in the claims, and the gist of the present disclosure is as follows.

(1) An aluminum scandium nitride film containing aluminum, scandium, and nitrogen, and further containing gallium.
(2) The aluminum scandium nitride film according to (1), in which a crystal phase of the aluminum scandium nitride film includes a hexagonal crystal.
(3) The aluminum scandium nitride film according to (2), in which the crystal phase of the aluminum scandium nitride film has a wurtzite structure.
(4) The aluminum scandium nitride film according to (3), in which an internal parameter u defined by formula (A) below is less than 1.0.

$$\text{Internal parameter } u = (a^2/3c^2) + 0.25 \cdots (A)$$

(In formula (A) above, a represents a lattice constant (Å) of an a-axis, and c represents a lattice constant (Å) of a c-axis.)
(5) The aluminum scandium nitride film according to (4), in which the internal parameter u is 0.30 or more and 0.50 or less.
(6) The aluminum scandium nitride film according to any one of (1) to (5), in which the aluminum scandium nitride film is represented by composition formula (B) below.

$$(Al_xSc_yGa_z)N \cdots \qquad (B)$$

(In formula (B) above, x is 0.4 or more and 0.6 or less, y is 0.1 or more and 0.5 or less, z is 0.1 or more and 0.3 or less, and x + y + z is 1.)

(7) The aluminum scandium nitride film according to any one of (1) to (6), having a thickness of 2,000 nm or less.

(8) The aluminum scandium nitride film according to any one of (1) to (7), having a thickness of 250 nm or less.

(9) The aluminum scandium nitride film according to any one of (1) to (7), having a thickness of more than 250 nm.

(10) A ferroelectric element including the aluminum scandium nitride film according to any one of (1) to (9).

**Advantageous Effects of Invention**

According to the present disclosure, there is provided at least one of an aluminum scandium nitride film and a ferroelectric element capable of increasing the remanent polarization while decreasing the coercive electric field.

**Brief Description of Drawings**

[Fig. 1] Fig. 1 is a sectional view illustrating a ferroelectric element according to an embodiment of the present disclosure.

[Fig. 2] Fig. 2 is a graph showing an X-ray diffraction profile of an aluminum scandium nitride film of Example 1, obtained by an out-of-plane method.

[Fig. 3] Fig. 3 is a graph showing an X-ray diffraction profile of an aluminum scandium nitride film of Example 1, obtained by an in-plane method.

**Description of Embodiments**

Embodiments of the present disclosure will be described in detail with reference to an example. However, the present disclosure is not limited to the embodiments below.

<Aluminum scandium nitride film>

First, an embodiment of an aluminum scandium nitride film according to the present disclosure will be described.

The aluminum scandium nitride film contains aluminum, scandium, and nitrogen, and further contains gallium.

According to this aluminum scandium nitride film, the remanent polarization can be increased while the coercive electric field is decreased. Accordingly, driving can be performed with low power consumption, and furthermore, it is expected that compact ferroelectric elements can be realized.

One possible reason why the above effect is obtained is as follows. Since the atomic radius of gallium is close to that of aluminum or the like, replacing some aluminum or scandium of aluminum scandium nitride (AlScN) with gallium easily causes distortion of AlScN crystals and easily reverses polarization, and consequently decreases the coercive electric field. A possible reason of the increase in the remanent polarization is that polarization is likely to change near the coercive electric field, so that the shape of the hysteresis curve becomes close to an ideal quadrangular shape.

The crystal phase of the aluminum scandium nitride film includes a hexagonal crystal, is preferably composed of a hexagonal crystal, and more preferably has a wurtzite structure.

In the aluminum scandium nitride film, the crystal is preferably distorted, and an internal parameter u defined by formula (A) below is preferably less than 1.0.

$$\text{Internal parameter } u = (a^2/3c^2) + 0.25 \cdots (A)$$

(In formula (A) above, a represents a lattice constant (Å) of the a-axis, and c represents a lattice constant (Å) of the c-axis.)

The internal parameter u is one of an indicator indicating distortion of a crystal, and means that the smaller the value thereof, the lager the distortion. Decreasing the internal parameter can further increase the remanent polarization. The internal parameter u is preferably 0.30 or more and 0.50 or less, more preferably 0.35 or more and 0.40 or less.

The aluminum scandium nitride film is represented by, for example, composition formula (B) below.

$$(Al_xSc_yGa_z)N \cdots \qquad (B)$$

In formula (B) above, x is more than 0 and less than 1 but is preferably 0.1 or more, 0.2 or more, 0.3 or more, or 0.4 or more. In this case, the remanent polarization (Pr) is likely to increase.

However, x is preferably 0.99 or less and may be 0.95 or less, 0.7 or less, or 0.5 or less. In this case, the remanent polarization is large, and the difference between the coercive electric field and the dielectric breakdown electric field increases.

In formula (B) above, y is more than 0 and less than 1 and is 0.1 or more, 0.15 or more, 0.3 or more, or 0.4 or more.

However, y is preferably 0.95 or less and may be 0.6 or less, 0.5 or less, 0.4 or less, or 0.3 or less. In this case, the coercive electric field (Ec) is more likely to decrease.

In formula (B) above, z is represented by 1-x-y, is more than 0 and less than 1, and is more preferably 0.05 or more, 0.1 or more, or 0.15 or more. When z is 0.05 or more, the wurtzite structure is easily maintained in a state where the Sc proportion is high, and the coercive electric field (Ec) is more likely to decrease.

However, z is preferably 0.95 or less and may be 0.9 or less, 0.5 or less, 0.3 or less, or 0.2 or less. In this case, the crystal phase of the aluminum scandium nitride film tends to have a wurtzite structure.

In formula (B) above, x is preferably 0.3 or more and 0.7 or less, y is preferably 0.1 or more and 0.6 or less, and z is preferably 0.05 or more and 0.4 or less. In this case, in particular, the coercive electric field is likely to decrease. Furthermore, in formula (B) above, it is preferable that x be 0.4 or more and 0.6 or less, y be 0.2 or more and 0.5 or less, and z be 0.1 or more and 0.3 or less.

The thickness of the aluminum scandium nitride film is not particularly limited, but may be 10,000 nm or less, 2,000 nm or less, 1,500 nm or less, 1,000 nm or less, 500 nm or less, or 250 nm or less.

The thickness of the aluminum scandium nitride film may be 1 nm or more, 2 nm or more, 3 nm or more, 50 nm or more, 100 nm or more, or 175 nm or more.

When the aluminum scandium nitride film is used in ferroelectric element applications, the thickness of the aluminum scandium nitride film is preferably small. Specifically, the thickness of the aluminum scandium nitride film is preferably 250 nm or less. In this case, the ferroelectric element can be used with lower power consumption. The thickness of the aluminum scandium nitride film may be 200 nm or less, 150 nm or less, 100 nm or less, 50 nm or less, or 20 nm or less. However, the thickness of the aluminum scandium nitride film may be 1 nm or more, 2 nm or more, 3 nm or more, or 5 nm or more.

When the aluminum scandium nitride film is used in piezoelectric element applications, the thickness of the aluminum scandium nitride film is preferably more than 250 nm. The thickness of the aluminum scandium nitride film is more preferably 400 nm or more, particularly preferably 500 nm or more. However, the thickness of the aluminum scandium nitride film may be 10,000 nm or less, 5,000 nm or less, or 1,000 nm or less.

<Method for producing aluminum scandium nitride film>

The aluminum scandium nitride film of the present embodiment may be produced by any method as long as the above characteristics are satisfied. For example, the aluminum scandium nitride film of the present embodiment is obtained by a production method including a step of forming a film by sputtering an aluminum target, a scandium target, and a gallium nitride target. Preferably, the aluminum scandium nitride film of the present embodiment is obtained by a production method including a step of forming a film on a substrate by sputtering an aluminum target, a scandium target, and a gallium nitride target.

The gallium nitride target includes gallium nitride. The gallium nitride is bulk containing gallium nitride as a main component, and may be in the form of at least one of a single crystal and a polycrystal containing gallium nitride as a main component or in the form of a polycrystal containing gallium nitride as a main component. The gallium nitride in the gallium nitride target may contain indium or aluminum as a dopant and silicon or the like in order to exhibit conductive properties or semiconductor physical properties. The "main component" as used herein refers to a component with a content of 50% by mass or more.

The crystal structure of gallium nitride preferably includes a hexagonal crystal structure and is more preferably a hexagonal crystal structure.

The aluminum target includes aluminum. The aluminum is bulk containing aluminum as a main component, and is in the form of at least one of a single crystal and a polycrystal containing aluminum as a main component or in the form of a polycrystal containing aluminum as a main component. The aluminum in the aluminum target may contain at least one of indium and gallium as a dopant or silicon or the like in order to exhibit conductive properties or semiconductor physical properties.

The scandium target includes scandium. The scandium is bulk containing scandium as a main component, and is in the form of at least one of a single crystal and a polycrystal containing scandium as a main component or in the form of a polycrystal containing scandium as a main component. The scandium in the scandium target may contain indium or gallium as a dopant or silicon or the like in order to exhibit conductive properties or semiconductor physical properties.

The aluminum target, the scandium target, and the gallium nitride target may each include a backing plate joined to the bulk included in the target.

Each of the targets may further include a joining material between the bulk and the backing plate. Various materials can be used as the joining material, but indium is preferred from the viewpoint of suppressing thermal diffusion and thermal expansion during sputtering.

The substrate used for the film formation includes a support base. The support base is not particularly limited, but can be, for example, at least one of a silicon substrate and a glass substrate. Examples of the support base include silicon substrates, silicon carbide substrates, glass substrates containing alkali-free glass, quartz, or the like, substrates whose crystal phases have a wurtzite structure, such as gallium nitride substrates, and oxide crystal substrates, such as sapphire and magnesia substrates. Of these, the support base is preferably a silicon substrate.

The substrate may further include an oxide layer on the support base as necessary. Examples of the oxide that forms the oxide layer include titania and silica. The oxide layer may be a single layer or a stack composed of a plurality of layers.

As the sputtering method, one or more selected from the group consisting of a DC sputtering method, an RF sputtering method, an AC sputtering method, a DC magnetron sputtering method, an RF magnetron sputtering method, an ECR sputtering method, a pulsed laser deposition method, and an ion beam sputtering method can be appropriately selected. Of these, at least one of the DC magnetron sputtering method and the RF magnetron sputtering method is preferred from the viewpoint that a film can be formed over a large area uniformly and at a high speed.

The gas pressure during sputtering is not particularly limited but may be 20 mTorr or less. The lower the gas pressure during sputtering, the more particles (sputtered particles) released from the target are likely to reach the substrate while maintaining high energy, and are likely to be epitaxially rearranged. This easily provides a hexagonal aluminum scandium gallium nitride film.

The temperature of the substrate during film formation is preferably 700°C or lower, more preferably 600°C or lower. In this case, when the temperature of the substrate during film formation is 700°C or lower, the film formation time is shortened to improve throughput. The temperature of the substrate during film formation may be 150°C or higher or 200°C or higher.

The gas introduced is not particularly limited as long as the gas species causes sputtering upon discharge. Such a gas is, for example, at least one of nitrogen and argon. These may be used alone or as a mixture of the two. The gas introduced is preferably nitrogen. In this case, the remanent polarization tends to be larger.

The electric power during discharge may be appropriately adjusted for each target. The electric power of the target may be appropriately adjusted in a range of 0.49 W/cm$^2$ or more and 9.87 W/cm$^2$ or less. In this case, separation of coarse target particles from the target due to the power applied to the target is unlikely to occur. When the electric power during discharge is 2 W/cm$^2$ or more, plasma is stabilized, and the film formation rate is likely to increase. Note that the value of z in composition formula (B) above can be adjusted by adjusting the electric power of the gallium nitride target. For example, as the electric power of the target is increased, the value of z increases.

The film formation time may be adjusted as appropriate depending on the thickness of the aluminum scandium nitride film. As the film formation time is increased, the thickness of the aluminum scandium nitride film can be increased.

<Ferroelectric element>

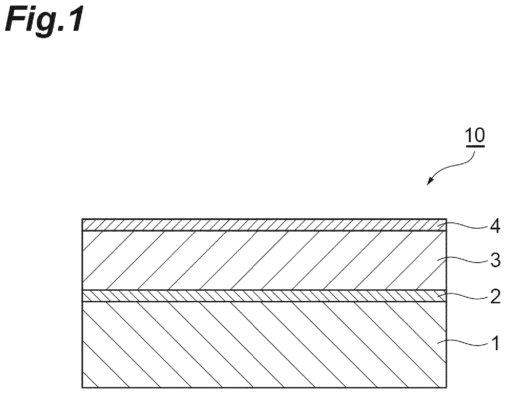

Next, a ferroelectric element of the present embodiment will be described with reference to Fig. 1. Fig. 1 is a sectional view illustrating a ferroelectric element of the present embodiment. As illustrated in Fig. 1, a ferroelectric element 10 includes, on a substrate 1, a first electrode 2, an aluminum scandium nitride film 3, and a second electrode 4 in this order.

According to this ferroelectric element 10, driving can be performed with low power consumption, and reduction in size can be realized.

The ferroelectric element 10 can be used as, for example, storage elements such as ferroelectric memories and piezoelectric elements such as pressure sensors and vibration sensors.

**Examples**

Hereinafter, the contents of the present disclosure will be described in more detail with reference to Examples and Comparative Examples. However, the present disclosure is not limited to Examples below.

(Example 1)

A silica (SiO$_2$) film having a thickness of 100 nm was formed on a support base formed of a crystalline silicon substrate (Miller index of the surface: (001)) with a size of 5 mm × 5 mm × 600 μm in thickness. Subsequently, a titania

($TiO_2$) film having a thickness of 50 nm was formed on the silica film. Next, a platinum (Pt) film (Miller index of the surface: (111)) having a thickness of 100 nm was formed on the titania film by an electron-beam evaporation method. Thus, a substrate for film formation with a thickness of 0.6 mm was obtained.

Next, the substrate for film formation obtained as described above, a gallium nitride (GaN) target below, an aluminum (Al) target below, and a scandium (Sc) target below were attached to a sputtering apparatus, and high-frequency ternary simultaneous reactive magnetron sputtering was performed at a substrate temperature of 400°C under film formation conditions described below to form an aluminum scandium nitride film on the Pt film of the substrate for film formation. Thus, a stack (aluminum scandium nitride film/platinum film/titania film/silica film/silicon substrate) including a Ga-containing aluminum scandium nitride film was obtained.

(Target)

· GaN target

A target obtained by joining a GaN polycrystal (sintered body) to a backing plate with an indium joining material therebetween (manufactured by TOSOH CORPORATION)

· Al target

A target obtained by joining an Al polycrystal (sintered body) to a backing plate with an indium joining material therebetween (manufactured by Kojundo Chemical Laboratory Co., Ltd.)

· Sc target

A target obtained by joining a Sc polycrystal (sintered body) to a backing plate with an indium joining material therebetween (manufactured by Kojundo Chemical Laboratory Co., Ltd.)

(Film formation conditions)

 · Magnetic field strength: 4,500 Gauss
 · Distance between Sc target and multilayer substrate: 120 mm
 · Distance between Al target and multilayer substrate: 120 mm
 · Distance between GaN target and multilayer substrate: 120 mm
 · Electric power of Sc target: 4.10 $W/cm^2$ (83 W)
 · Electric power of Al target: 5.77 $W/cm^2$ (117 W)
 · Electric power of GaN target: 0.99 $W/cm^2$ (20 W)
 · Substrate temperature during film formation: 400°C
 · Film formation time: 112 minutes
 · Type of introduced gas (Sputtering atmosphere): nitrogen ($N_2$)
 · Flow rate of introduced gas: 75 sccm
 · Pressure of gas during sputtering: 5 mTorr

(Example 2)

A stack including an aluminum scandium nitride film was obtained as in Example 1 except that the electric power of the Sc target (hereinafter, also referred to as an "output of a target") was changed to 5.08 $W/cm^2$ (103 W) and the output of the Al target was changed to 4.79 $W/cm^2$ (97 W), as shown in Table 1.

(Example 3)

A stack including an aluminum scandium nitride film was obtained as in Example 1 except that the output of the Sc target was changed to 73 W and the output of the Al target was changed to 127 W, as shown in Table 1.

(Example 4)

A stack including an aluminum scandium nitride film was obtained as in Example 1 except that the output of the Sc target was changed to 133 W and the output of the Al target was changed to 67 W, as shown in Table 1.

(Example 5)

A stack including an aluminum scandium nitride film was obtained as in Example 1 except that the output of the Sc target was changed to 103 W, the output of the Al target was changed to 97 W, and the output of the GaN target was changed to 10 W, as shown in Table 1.

(Example 6)

A stack including an aluminum scandium nitride film was obtained as in Example 1 except that the output of the Sc target was changed to 123 W, the output of the Al target was changed to 77 W, and the output of the GaN target was changed to 10 W, as shown in Table 1.

(Example 7)

A stack including an aluminum scandium nitride film was obtained as in Example 1 except that the output of the Sc target was changed to 143 W, the output of the Al target was changed to 77 W, and the output of the GaN target was changed to 40 W, as shown in Table 1.

(Example 8)

A stack including an aluminum scandium nitride film was obtained as in Example 1 except that the output of the Sc target was changed to 123 W, the output of the Al target was changed to 77 W, and the output of the GaN target was changed to 10 W, as shown in Table 1.

(Comparative Example 1)

A stack including a Ga-free aluminum scandium nitride film was obtained as in Example 1 except that the GaN target was not used, the output of the Sc target was changed to 70 W, and the output of the Al target was changed to 130 W, as shown in Table 1.

(Comparative Example 2)

A stack including a Ga-free aluminum scandium nitride film was obtained as in Example 1 except that the GaN target was not used, the output of the Sc target was changed to 50 W, and the output of the Al target was changed to 150 W, as shown in Table 1.

(Comparative Example 3)

A stack including a Ga-free aluminum scandium nitride film was obtained as in Example 1 except that the GaN target was not used, the output of the Sc target was changed to 60 W, and the output of the Al target was changed to 140 W, as shown in Table 1.

(Comparative Example 4)

A stack including a Ga-free aluminum scandium nitride film was obtained as in Example 1 except that the GaN target was not used, the output of the Sc target was changed to 107 W, and the output of the Al target was changed to 93 W, as shown in Table 1.

<Evaluation of aluminum scandium nitride film>

(1) Identification of crystal structure

For the aluminum scandium nitride films of the stacks of Examples 1 to 8 and Comparative Examples 1 to 4 obtained as described above, measurement of an X-ray diffraction profile by an out-of-plane method and measurement of an X-ray diffraction profile by an in-plane method were conducted to examine the type of crystal structure, the lattice constant a (Å) of the a-axis and the lattice constant c (Å) of the c-axis of a unit cell, c/a, and the internal parameter u. The out-of-plane method is a method for evaluating a lattice plane parallel to a sample surface, and θ-2θ scan was conducted using X'pert MRD (manufactured by Malvern Panalytical Ltd.) to perform X-ray diffraction measurement. The in-plane method is a method for evaluating a lattice plane perpendicular to a sample surface, and X-ray diffraction measurement was performed using Smart Lab (manufactured by Rigaku Corporation).

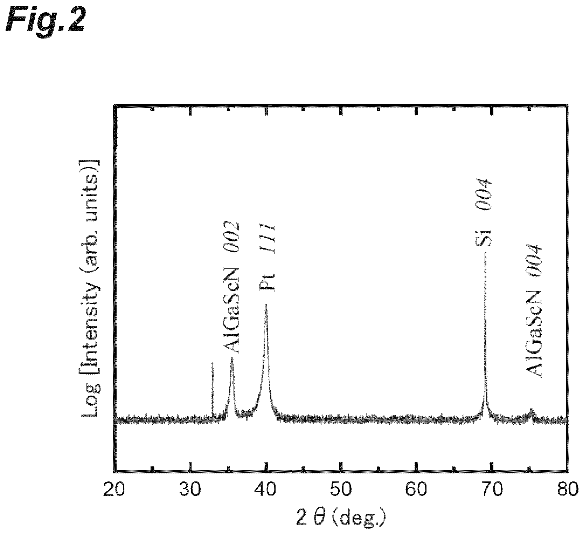

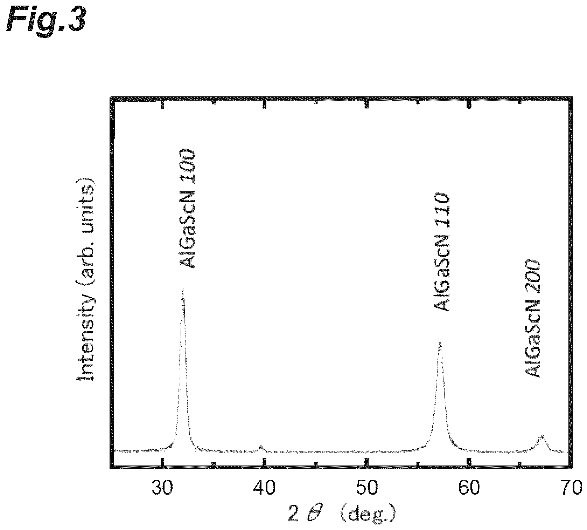

As a result, regarding Examples 1 to 8 and Comparative Examples 1 to 4, diffraction peaks of (002) and (004) were observed in the X-ray diffraction profile obtained by the out-of-plane method. Thus, it was found that the aluminum scandium nitride films had a crystalline phase with a wurtzite structure. The aluminum scandium nitride film of Example 1 had a lattice constant of the a-axis of 3.215 Å, a lattice constant of the c-axis of 5.045 Å, and an internal parameter u of 0.385. Regarding the aluminum scandium nitride films of Examples 2 to 8 and Comparative Examples 1 to 4, the internal parameters u were as shown in Table 1. The X-ray diffraction profile of Example 1 obtained by the out-of-plane method, and the X-ray diffraction profile of Example 1 obtained by the in-plane method are shown in Figs. 2 and 3, respectively.

(2) Identification of composition of crystal phase and film thickness

For the aluminum scandium nitride films of the stacks of Examples 1 to 8 and Comparative Examples 1 to 4, the composition of the crystal phase and the film thickness were determined using a wavelength dispersive X-ray fluorescence spectrometer (product name: PW4400, manufactured by Malvern Panalytical Ltd.). The results are shown in Table 1.

(3) Evaluation of ferroelectricity

On each of the aluminum scandium nitride films of the stacks of Examples 1 to 8 and Comparative Examples 1 to 4 obtained as described above, a platinum (Pt) electrode with a diameter of 50 $\mu$m and a thickness of 75 $\pm$ 25 nm was formed at room temperature by an electron-beam evaporation method to prepare samples.

Ferroelectricity of the samples was evaluated using a ferroelectric tester (product name: "FCE-1A", manufactured by TOYO Corporation). Specifically, a P-E measurement was performed at room temperature to measure polarization P with respect to electric field E by applying an applied electric field E (measurement frequency: 10 kHz), and the remanent polarization Pr and the coercive electric field Ec after five cycles were determined. The results are shown in Table 1. Note that, in Table 1, the remanent polarization Pr indicates the absolute value of the maximum remanent polarization Pr observed in the P-E measurement. The coercive electric field Ec indicates the absolute value of the electric field at an intersection point of the hysteresis curve obtained by the P-E measurement and P = 0.

(4) Evaluation of piezoelectric property

On each of the aluminum scandium nitride films of the stacks of Examples 7 and 8 and Comparative Example 4 obtained as described above, a platinum (Pt) electrode with a diameter of 50 $\mu$m and a thickness of 75 $\pm$ 25 nm was formed at room temperature by an electron-beam evaporation method to prepare samples.

The piezoelectric constants $d_{33}$ of the samples were measured at room temperature using a $d_{33}$ meter (product name: "PM300", manufactured by Piezo Test, Ltd.) to evaluate a piezoelectric property. The results are shown in Table 1.

[Table 1]

| | Target output (W) | | | Composition ($Al_xSc_yGa_z$)N | | | u | Film thickness | Remanent polarization Pr | Coercive electric field Ec | Piezoelectric constant $d_{33}$ |
|---|---|---|---|---|---|---|---|---|---|---|---|
| | Al | Sc | GaN | x | y | z | | nm | $\mu$C/cm$^2$ | MV/cm | pC/N |
| Example 1 | 117 | 83 | 20 | 0.60 | 0.20 | 0.20 | 0.385 | 220 | 157 | 5.2 | - |
| Example 2 | 97 | 103 | 20 | 0.50 | 0.30 | 0.20 | 0.387 | 200 | 127 | 4.6 | - |
| Example 3 | 127 | 73 | 20 | 0.70 | 0.10 | 0.20 | 0.383 | 220 | 137 | 5.5 | - |
| Example 4 | 67 | 133 | 20 | 0.40 | 0.30 | 0.30 | 0.389 | 190 | 137 | 4.2 | - |
| Example 5 | 97 | 103 | 10 | 0.50 | 0.40 | 0.10 | 0.393 | 200 | 135 | 4.8 | - |
| Example 6 | 77 | 123 | 10 | 0.40 | 0.50 | 0.10 | 0.404 | 180 | 87 | 3.7 | - |
| Example 7 | 77 | 143 | 40 | 0.23 | 0.29 | 0.48 | - | 531 | 5 | 3.6 | -2.7 |
| Example 8 | 77 | 123 | 10 | 0.45 | 0.50 | 0.05 | - | 424 | 41 | 3.3 | -7.1 |
| Comparative Example 1 | 130 | 70 | - | 0.80 | 0.20 | 0 | 0.387 | 150 | 129 | 5.7 | - |
| Comparative Example 2 | 150 | 50 | - | 0.90 | 0.10 | 0 | 0.384 | 130 | 138 | 7.2 | - |
| Comparative Example 3 | 140 | 60 | - | 0.85 | 0.15 | 0 | 0.384 | 140 | 133 | 6.7 | - |
| Comparative Example 4 | 93 | 107 | - | 0.69 | 0.31 | 0 | - | 383 | 63 | 5.9 | -1.9 |

It was found that the P-E curve of each of the aluminum scandium nitride films of Examples 1 to 8 and Comparative Examples 1 to 4 drew a hysteresis loop. Thus, it was confirmed that the aluminum scandium nitride films of Examples 1 to 8 and Comparative Examples 1 to 4 each had ferroelectricity.

In addition, the results shown in Table 1 showed that the values of the coercive electric field Ec of Examples 1 to 8 were lower than the values of the coercive electric field Ec of Comparative Examples 1 to 4.

This demonstrated that in the aluminum scandium nitride films of Examples 1 to 8, the coercive electric field Ec could be reduced compared with the aluminum scandium nitride films of Comparative Examples 1 to 4, and the remanent polarization Pr could be increased.

In addition, the results shown in Table 1 showed that the absolute values of the piezoelectric constants $d_{33}$ of the aluminum scandium nitride films of Examples 7 and 8 were larger than the absolute value of the piezoelectric constant $d_{33}$ of the aluminum scandium nitride film of Comparative Example 4. Thus, it was found that the ferroelectric element according to the present disclosure could also be used as a piezoelectric element.

**Reference Signs List**

1     substrate
2     first electrode
3     aluminum scandium nitride film
4     second electrode
10   ferroelectric element

**Claims**

1. An aluminum scandium nitride film comprising aluminum, scandium, and nitrogen, and further comprising gallium.

2. The aluminum scandium nitride film according to claim 1, wherein a crystal phase of the aluminum scandium nitride film includes a hexagonal crystal.

3. The aluminum scandium nitride film according to claim 2, wherein the crystal phase has a wurtzite structure.

4. The aluminum scandium nitride film according to claim 3, wherein an internal parameter u defined by formula (A) below is less than 1.0:

$$\text{Internal parameter } u = (a^2/3c^2) + 0.25 \cdots (A)$$

(in formula (A) above, a represents a lattice constant (Å) of an a-axis, and c represents a lattice constant (Å) of a c-axis.)

5. The aluminum scandium nitride film according to claim 4, wherein the internal parameter u is 0.30 or more and 0.50 or less.

6. The aluminum scandium nitride film according to claim 1, wherein the aluminum scandium nitride film is represented by composition formula (B) below:

$$(Al_xSc_yGa_z)N \cdots \qquad (B)$$

(in formula (B) above, x is 0.4 or more and 0.6 or less, y is 0.1 or more and 0.5 or less, z is 0.1 or more and 0.3 or less, and x + y + z is 1.)

7. The aluminum scandium nitride film according to claim 1, having a thickness of 2,000 nm or less.

8. The aluminum scandium nitride film according to claim 7, having a thickness of 250 nm or less.

9. The aluminum scandium nitride film according to claim 1, having a thickness of more than 250 nm.

**10.** A ferroelectric element comprising the aluminum scandium nitride film according to any one of claims 1 to 9.

*Fig.1*

# *Fig.2*

*Fig.3*

## INTERNATIONAL SEARCH REPORT

| International application No. |
| --- |
| **PCT/JP2023/013181** |

**A. CLASSIFICATION OF SUBJECT MATTER**

*C23C 14/06*(2006.01)i; *H01L 21/318*(2006.01)i; *H10B 53/30*(2023.01)i; *H10N 30/076*(2023.01)i; *H10N 30/853*(2023.01)i
FI: C23C14/06 L; C23C14/06 A; H10B53/30; H10N30/853; H10N30/076; H01L21/318 B

According to International Patent Classification (IPC) or to both national classification and IPC

**B. FIELDS SEARCHED**

Minimum documentation searched (classification system followed by classification symbols)

C23C14/06; H01L21/318; H10B53/30; H10N30/076; H10N30/853

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WANG, Ping et al., Quaternary alloy ScAlGaN: A promising strategy to improve the quality of ScAlN, Applied Physics Letters, 04 January 2022, doi: 10.1063/5.0060608<br>    Abstract, table 1, sample S8 | 1-10 |
| X | GREEN, Andrew J. et al., RF power performance of Sc(Al,Ga)N/GaN HEMTs at Ka-band, IEEE electron device letters, August 2020, doi: 10.1109/LED.2020.3006035<br>    II. Epitaxial growth and device fabrication | 1-5, 7-8, 10 |
| A | | 6, 9 |
| X | ITO, Kazuya et al., Giant electromechanical coupling in c-axis oriented ScAlGaN films, Proceedings of symposium on ultrasonic electronics, November 2012, doi: 10.24492/use.33.0_415<br>    Introduction, fig. 1, table 1 | 1–5, 9–10 |
| A | | 6-8 |

☐ Further documents are listed in the continuation of Box C.    ☐ See patent family annex.

| | |
| --- | --- |
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **15 June 2023** | **27 June 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YASUOKA et al.** Effects of deposition conditions on the ferroelectric properties of (Al1-xScx)N thin films. *J. Appl. Phys.*, 2020, vol. 128, 114103